# EUROPEAN PATENT SPECIFICATION

(11) **EP 0 444 757 B1**
(45) Date of publication and mention of the grant of the patent: **13.09.1995**
(21) Application number: 91200414.0
(22) Date of filing: 26.02.1991
(51) Int. Cl.: H01H 9/54

(54) **Power on/off circuit with lock function**
Ein-/Aus- Schaltung mit Verrieglungsfunktion
Circuit d'enclenchement/déclenchement d'alimentation avec vérouillage

(30) Priority: 01.03.1990 JP 49817/90
(43) Date of publication of application: 04.09.1991
(73) Proprietor: Philips Electronics N.V., 5621 BA Eindhoven (NL)
(72) Inventor: Abe, Katsumi, NL-5656 AA Eindhoven (NL); Takie, Akinori, NL-5656 AA Eindhoven (NL)
(74) Representative: Faessen, Louis Marie Hubertus

(56) References cited:
- FR-A- 2 613 270
- US-A- 3 746 938
- PATENT ABSTRACTS OF JAPAN vol. 13, no. 117 (E-731)(3465)22 March 1989; & JP-A-63 287 326 ( FUJITSU LTD ) 24 November 1988.
- ELECTRONIC ENGINEERING. vol. 47, no. 569, July 1975; pages 14-15, LONDON GB, pages 14-15; MORLEY, D: "Touch operated on-off switch using cmos nor gates"

## Description

### Field of the invention.

This invention relates to a power on/off circuit with lock function comprising a power supply and a load, a main switch and a lock switch arranged to enable and disable a connection between the power supply and the load by means of the main switch if the lock switch is in a first and second position respectively.

### Background of the invention.

Portable shavers are equipped with the main switch which turns a motor on/off, and a locking system which stops this function. The locking system is provided to prevent the main switch from being accidentally turned on due to an external shock and the like, so that the motor will not rotate consuming batteries consequently, when the portable shaver is contained and carried in a suitcase and the like.

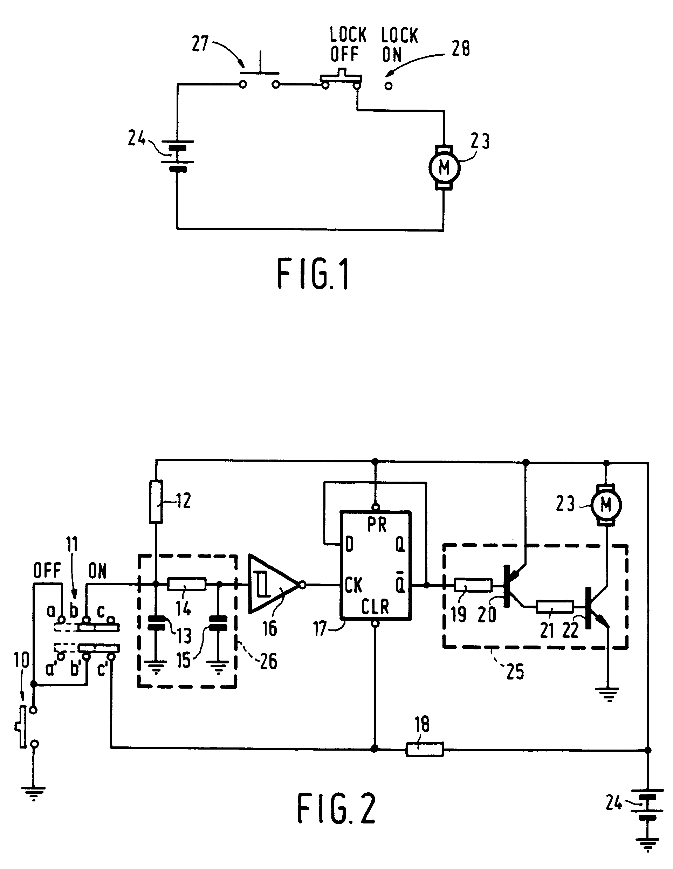

As practical means for realizing this locking system, there are known mechanical locking means and electrical means utilizing a slide switch. Mechanical locking means are arranged so that the switch bar of the main switch is mechanically locked to prevent it from moving to the on-position when the main switch is in the off-position, and the main switch is not mechanically locked when the main switch is in the on-position. On the other hand, as shown in Fig. 1, with the locking system using electrical means, a locked state is realized by turning a lock slide switch 28, which is connected in series with a main switch 27, to the off-position, so that the power to the load will be cut off.

In recent years, push type switches have come into use widely as the main switch. The push type switches are a type which is turned on/off by depressing a switch button, and there are types in which the depressed state is held (alternate type) and types in which the depressed state returns to the previous state as soon as the finger is removed (momentary type). Especially, soft touch momentary type switches are used frequently nowadays.

In battery operated portable shavers utilizing a momentary type switch as the main switch (hereinafter referred to as momentary switch type shavers), a pulse is generated each time the main switch is depressed, and the switched state is held by means of a state holding circuit until the next pulse is sent.

As shown in Fig. 1, in conventional shavers in which an alternate type main switch 27 and a lock switch 28 are connected in series, the rotation of a motor 23 is stopped when the lock switch 28 is turned on with the main switch 27 in the on state. Thus, the motor can be stopped not only by the main switch but also by the lock switch. This results in a problem that it is impossible to determine which switch is the main switch.

Such a problem does not exist when a mechanical locking system is used. However, locking means utilizing a mechanical means cannot be used in momentary switch type shavers. This is because a switch on/off signal cannot be sent to the state holding circuit when the main switch operation is disabled by the mechanical means. On the other hand, if a microprocessor is used, it is possible to realize a momentary switch type shaver in which the function of the main switch and lock switch are clearly separated. However, microprocessors are rather expensive and require expensive development costs for making its software.

Momentary type switches have recently come into use not only in shavers as mentioned above but as the main switch of headphone stereo sets. However, headphone stereo sets are conventionally not equipped with a lock switch. Therefore, when a headphone stereo set having this type of main switch is carried in a pocket and the like, there is a problem that the main switch can be depressed, and the headphone stereo set operates, and consequently the battery is consumed completely.

### Summary of the invention.

Object of the invention is to provide a power on/off circuit with lock function not having the aforementioned problems. This object is, according to the invention, realised by a power on/off circuit as specified in the opening paragraph which is characterized in that the main switch is a momentary type switch, the lock switch is a two-switching circuit two-contact type switch, the power on/off circuit further comprises a switching state holding circuit, one of the switching circuits of the lock switch being connected between the main switch and an input terminal of the switching state holding circuit, the other switching circuit of the lock switch being connected between the main switch and a reset terminal of the switching state holding circuit.

With this circuit, the state of the main switch is held by the switching state holding circuit, and the state is held unless a reset signal is given to the switching state holding circuit. Since the lock switch has only the function of generating the reset signal, there is no possibility that the lock switch will cut off the supply of current to the load. This means that the motor is not turned on/off by the lock switch and therefore it is possible to clearly separate the function of the main switch and lock switch.

Moreover, this lock function can be realized using a cheap flip flop without using an expensive microprocessor.

Also, when this power on/off circuit with lock function is incorporated in electronic devices such as headphone stereo sets which utilize a momentary type switch as the main switch, there is no possibility of cancellation of the on-state of the lock switch resulting in turning off of the main switch even if the electronic devices are contained and carried in a suitcase, and thus the accident that the battery is consumed completely will not happen.

A first embodiment of the power on/off circuit with lock function is characterized in that a low pass filter is provided between the input terminal of the switching state holding circuit and the one of the switching circuits of the lock switch. The low pass filter between the input terminal of the switching state holding circuit and one of the circuits of lock switch, prevents malfunction due to noise.

It is preferable to use a D type flip flop as the switching state holding circuit of the power on/off circuit.

In particular when conductive rubber is used for the switch contact of the main switch, a wave shaping circuit in front of the switching state holding circuit is suitable.

### Brief explanation of the drawings.

An embodiment of the invention will now be described in more detail, by way of example, with reference to the accompanying drawings, wherein
- Figure 1 shows a prior art power on/off circuit with lock function, and
- Figure 2 shows a power on/off circuit with lock function according to the invention.

### Description of embodiments.

Figure 2 shows an embodiment, wherein the power on/off circuit according to the invention is used in a momentary switch type shaver. The power on/off circuit with lock function consists of a main switch 10, a lock switch 11, a low pass filter 26, a wave forming circuit 16, a switching state holding circuit 17, a motor 23 and a driving circuit 25 thereof, and a battery 24.

The main switch 10 comprises a soft touch momentary type switch which is a kind of push type switch, and one of its contacts is connected to ground while the other contact is connected to a contact a and a contact b′ of a slide type lock switch 11.

The momentary type switch is a type of switch in which a pulse is generated each time a push button is depressed and the push button returns to the previous state instantaneously. The soft touch feeling can be obtained by using conductive rubber for the contact portion of the main switch 10. This conductive rubber contact improves the feel of using the switch, whereas the intrinsic resistance of the rubber itself degrades the rising characteristic of the waveform of the pulses which are generated by turning the contact on/off.

The lock switch 11 is a two-circuit two contact slide switch which, through the movement of a slide piece, realizes a lock-on-state as shown, wherein contacts b and b′ are connected to contacts c and c′ respectively, and a lock-cancellation-state or lock-off-state, wherein contacts b and b′ are connected to contacts a and a′ respectively. The contact b is connected to the input of the low pass filter 26, and the contact c′ is connected to a reset terminal of the switching state holding circuit 17.

The respective contacts of the main switch 10 and lock switch 11 may be formed on a printed circuit board. In this case, since it is not necessary to obtain each contact as an individual part, the manufacturing cost of shavers may be reduced.

The low pass filter 26 comprises a resistor 14 and capacitors 13 and 15. The resistor 14 is connected between the input and the output of the low pass filter 26 and the capacitors 13 and 15 are connected between ground and the input, respectively output of the low pass filter 26. The output thereof is connected to the input terminal of the wave forming circuit 16. The low pass filter 26 is provided to prevent malfunction of the switching state holding circuit 17 due to noise including high frequency components and contact noise (chattering) which are generated when the main switch 10 is activated. This low pass filter may be removed where the malfunction due to noise is not a concern. A pull up resistor 12 is connected between the input of the low pass filter 26 and the positive pole of the battery 24.

A Schmitt trigger inverter is used as the wave forming circuit 16. It outputs a reshaped pulse in response to an input voltage exceeding a certain threshold. In particular when a soft touch momentary push type switch which uses conductive rubber for the contact of the main switch 10 is used, the rising characteristic of the pulse generated by this switch is not suitable to trigger the holding circuit 17. The waveform is then reshaped in the Schmitt trigger inverter 16.

A D type flip flop is used as the switching state holding circuit 17. The output of the Schmitt trigger inverter 16 is connected to the clock terminal CK of the D type flip flop. The preset terminal PR of the flip flop is connected to the positive pole of the battery 24 and set at H (high) level. Further, the Q̅ output terminal of the flip flop is connected to a D input terminal and the motor driving circuit 25.

The motor driving circuit 25 is formed by Darlington-connected PNP transistor 20 and NPN transistor 22.

The motor 23 is connected between the positive pole of the battery 24 and the collector of the NPN transistor 22.

The reset terminal CLR of the D type flip flop is connected to the positive pole of the battery 24 through a pull up resistor 18.

When power supply is connected (in practice, when the batteries are set), a voltage at H level is applied to the preset terminal PR and reset terminal CLR of the D type flip flop, the output Q̅ becomes H level. Since a voltage at H level is applied to the base of the PNP transistor 20, the PNP transistor turns off. This causes the NPN transistor 22 to also turn off, and as a result, no current is supplied to the motor 23.

When the button of the main switch 10 is depressed under the condition that the slide piece of the lock switch 11 has been moved to the off position as shown in the figure by dotted lines (the locked state has been cancelled), a pulse is generated and it is sent to the low pass filter 26 via contacts a and b. The pulse passes the low pass filter 26 and is applied to the clock terminal CK of the D type flip flop, the terminal Q̅ is switched from H level to L (low) level because both the preset PR terminal and reset CLR terminal have already been set at H level. Thus a current flows to the base of the PNP transistor 20, which causes a base current to flow to the NPN transistor 22 resulting in a current to be supplied to the motor 23.

Next, when the main switch 10 is depressed again, a pulse is given to the clock terminal of the D type flip flop again and the output Q̅ undergoes inversion from L level to H level thereby causing the motor driving circuit 25 to stop the supply of the current to the motor 23.

Thus, as long as the lock switch 11 is in off position, the motor can be turned on/off each time the main switch 10 is depressed.

Since a new pulse is not applied to the clock terminal of the D type flip flop, even if the lock switch 11 is slided to the lock-on position while the motor 23 is being driven (the state wherein the slide piece is in the on position as shown in the figure), the L level of the output Q̅ is held as it is, and the motor driving circuit 25 continues to supply the current to the motor 23. Therefore, the lock switch 11 does not function in this case.

If the main switch 10 is depressed in the lock-on-state of lock switch 11, the reset terminal of the D type flip flop becomes the ground level through the contacts b′ and c′, and the D type flip flop is reset. As a result, the output Q̅ becomes H level and the motor driving circuit 25 stops supplying current to the motor 23.

Thereafter, since the circuit from the main switch 10 to the clock terminal of the D type flip flop is disconnected, pressing the main switch 10 again does not cause re-inversion of the Q̅ terminal of the D type flip flop 17, and the motor 23 is thus kept off.

As a contact of the main switch 10, a metal contact may be used instead of conductive rubber. In this case, the wave forming circuit 16 may be omitted because the pulse generated by a metal contact abruptly rises. However, in this case, the switching state holding circuit 17 must respond to the falling edge of the pulse.

In the above embodiment, an example of the application of the power on/off circuit of this invention to a shaver has been described. The application of the power on/off circuit of this invention is not limited thereto and it may also be applied to other portable electronic devices such as headphone stereo sets and the like. In this case, the power on/off circuit of this invention may be used by replacing the portion of the motor 23 in Fig. 2 with the electrical of the portable electronic device.

## Claims

1. Power on/off circuit with lock function comprising a power supply (24) and a load (23), a main switch (10) and a lock switch (11) arranged to enable and disable a connection between the power supply and the load by means of the main switch if the lock switch is in a first and second position respectively, characterized in that the main switch is a momentary type switch, the lock switch is a two-switching circuit two-contact type switch, the power on/off circuit further comprises a switching state holding circuit (17), one of the switching circuits of the lock switch being connected between the main switch and an input terminal of the switching state holding circuit, the other switching circuit of the lock switch being connected between the main switch and a reset terminal of the switching state holding circuit.

2. A circuit according to Claim 1, characterized in that a low pass filter (26) is provided between the input terminal of the switching state holding circuit and the one of the switching circuits of the lock switch.

3. A circuit according to Claim 1 or 2, characterized in that the switching state holding circuit is a D type flip flop.

4. A circuit according to Claim 1, 2 or 3, characterized in that a wave forming circuit (16) is provided in front of the input terminal of the switching state holding circuit.

5. A circuit according to Claim 4, characterized in that the switching contact of the main switch is a conductive rubber contact.

6. A circuit according to Claim 1, 2, 3, 4 or 5, characterized in that the load is a motor and a motor driving circuit (25).

7. A circuit according to Claim 6, characterized in that the motor driving circuit is a circuit comprising transistors in Darlington connection.

## Patentansprüche

1. Ein/Aus-Schaltung mit Verriegelfunktion mit einer Stromversorgung (24) und einer Belastung (23), einem Hauptschalter (10) und einem Verriegelschalter (11) zum Herstellen oder Unterbrechen einer Verbindung zwischen der Stromversorgung und der Belastung mit Hilfe des Hauptschalters, wenn der Verriegelschalter in einer ersten bzw. in einer zweiten Stellung steht. dadurch gekennzeichnet, daß der Hauptschalter ein Momentanschalter ist, der Verriegelschalter ein Zweikontaktschalter mit einer Zweibetriebschaltung ist, die Ein/Aus-Schaltung außerdem eine Schaltzustandhalteschaltung (13) enthält, eine der Betriebsschalter des Verriegelschalters zwischen dem Hauptschalter und einer Eingangsklemme der Schaltzustandhalteschaltung angeschlossen ist, und die andere Betriebsschaltung des Verriegelschalters zwischen dem Hauptschalter und einer Rückstellklemme der Schaltzustandhalteschaltung angeschlossen ist.

2. Schaltung nach Anspruch 1, dadurch gekennzeichnet, daß zwischen der Eingangsklemme der Schaltzustandhalteschaltung und der einen der Betriebsschaltungen des Verriegelschalters ein Tiefpaßfilter (26) angeordnet ist.

3. Schaltung nach Anspruch 1 oder 2, dadurch gekennzeichnet, daß die Schaltzustandhalteschaltung ein D-Flipflop ist.

4. Schaltung nach Anspruch 1, 2 oder 3, dadurch gekennzeichnet, daß eine Wellenbildungschaltung (16) vor der Eingangsklemme der Schaltzustandhalteschaltung angeordnet ist.

5. Schaltung nach Anspruch 4, dadurch gekennzeichnet, daß der Schaltkontakt des Hauptschalters ein Leitgummikontakt ist.

6. Schaltung nach Anspruch 1, 2, 3, 4 oder 5, dadurch gekennzeichnet, daß die Belastung ein Motor und eine Motorsteuerschaltung (25) ist.

7. Schaltung nach Anspruch 6, dadurch gekennzeichnet, daß die Motorsteuerschaltung eine Schaltung mit Transistoren in Darlingtonschaltung ist.

## Revendications

1. Circuit d'enclenchement/déclenchement d'alimentation avec fonction de verrouillage comprenant une source alimentation électrique (24) et une charge (23), un commutateur principal (10) et un commutateur de verrouillage (11) destiné à ouvrir et fermer une connexion entre l'alimentation électrique et la charge au moyen du commutateur principal si le commutateur de verrouillage se trouve respectivement dans une première ou deuxième position, caractérisé en ce que le commutateur principal est un commutateur de type sans maintien, le commutateur de verrouillage est un commutateur de type à deux contacts et deux circuits de commutation, le circuit d'enclenchement/déclenchement d'alimentation comprend, par ailleurs, un circuit de maintien de l'état de commutation (17), l'un des circuits de commutation du commutateur de verrouillage étant monté entre le commutateur principal et une borne d'entrée du circuit de maintien de l'état de commutation, l'autre circuit de commutation du commutateur de verrouillage étant monté entre le commutateur principal et une borne de réinitialisation du circuit de maintien de l'état de commutation.

2. Circuit selon la revendication 1, caractérisé en ce qu'un filtre passe-bas (26) est prévu entre la borne d'entrée du circuit de maintien de l'état de commutation et celle des circuits de commutation du commutateur de verrouillage.

3. Circuit selon la revendication 1 ou 2, caractérisé en ce que le circuit de maintien de l'état de commutation est une bascule bistable de type D.

4. Circuit selon la revendication 1, 2 ou 3, caractérisé en ce qu'un circuit générateur d'ondes (16) est prévu en amont de la borne d'entrée du circuit de maintien de l'état de commutation.

5. Circuit selon la revendication 4, caractérisé en ce que le contact de commutation du commutateur principal est un contact en caoutchouc conducteur.

6. Circuit selon la revendication 1, 2, 3, 4 ou 5, caractérisé en ce que la charge est un moteur et un circuit d'entraînement d'un moteur (25).

7. Circuit selon la revendication 6, caractérisé en ce que le circuit d'entraînement du moteur est un circuit composé de transistors en montage Darlington.
